Europäisches Patentamt

European Patent Office

Office européen des brevets

(19)

(11) Veröffentlichungsnummer: **0 060 321**
**B1**

(12) **EUROPÄISCHE PATENTSCHRIFT**

(45) Veröffentlichungstag der Patentschrift:
**25.09.85**

(21) Anmeldenummer: **81108597.6**

(22) Anmeldetag: **20.10.81**

(51) Int. Cl.⁴: **G 01 R 31/28**

(54) **Verfahren für eine rasche interne Logikprüfung an integrierten Schaltungen.**

(30) Priorität: **16.03.81 DE 3110140**

(43) Veröffentlichungstag der Anmeldung:
**22.09.82 Patentblatt 82/38**

(45) Bekanntmachung des Hinweises auf die Patenterteilung:
**25.09.85 Patentblatt 85/39**

(84) Benannte Vertragsstaaten:
**DE FR GB NL**

(56) Entgegenhaltungen:
**US - A - 3 796 947**

**IBM TECHNICAL DISCLOSURE BULLETIN Band 17, Nr.
8, Januar 1975, Armonk G.V. LUKIANOFF "Simultaneous
Display of Voltage Phats and Signal Progression in an
Integrated Circuit" Seiten 2291 bis 2293
IEEE Journal of Solid-State Circ., Vol. SC-14, No. 2, Apr.
1979, pp. 471-481
NTG-Fachberichte, Bd. 68, VDE-Verlag GmbH, Berlin, S.
149-152, 1979
Scranning Electron Microscopy, 1978, Vol. 1, pp. 795-800
Digest of papers IEEE Test-Conference, 1980, pp.
444-449
Technisches Messen tm, 1981, H. 1, S. 29-35
Electronic Design, Vol. 28, 1980, 7, S. 48-56
Beiträge zur electronenmikroskopischen**

(73) Patentinhaber: **Siemens Aktiengesellschaft, Berlin und
München Wittelsbacherplatz 2, D-8000 München 2 (DE)**

(72) Erfinder: **Fazekas, Peter, Dipl.-Ing., Stuntzstrasse 21,
D-8000 München 80 (DE)**

(56) Entgegenhaltungen: (Fortsetzung)
**Direktabbildung von Oberflächen, 11. S. 67-71, 1978
Proc. of the IEEE, Vol. 66, No. 8, pp. 984-985, 1978
Scranning Electron Microscopy, 1976, pp. 615-624
Journal of Physics E Scientific Instruments, Vol. 10, No.
9, pp. 911-913, 1977
Proc. of IEEE International Conference on Circuits and
Computers, 1980, pp. 548-551
Scranning Electron Microscopy, 1979, pp. 285-296**

## Beschreibung

Die Erfindung betrifft ein Verfahren nach dem Oberbegriff des Anspruchs 1.

Für die Schaltungsanalyse während der Entwicklungsphase von Mikroprozessoren und Mikrocomputern mit immer grösser werdenden Datenbreiten sind neue Messtechniken erforderlich. Bei der Suche nach Schaltungsfehlern oder Designschwächen an komplexen integrierten Logikschaltungen genügt es nicht allein, Messungen mit hoher Zeit- und Spannungsauflösung an kritischen Schaltungsknoten durchzuführen. Um eine gesicherte Aussage über das Fehlverhalten eines Schaltungsteils machen zu können, müssen oft zusätzlich mehrere interne Steuer- und Datenleitungen überprüft werden. Die Messung dieser Signale dient als Überblick über das logische Zusammenarbeiten einzelner Schaltungsteile und soll zeigen, ob dem untersuchten Bereich alle nötigen Eingangssignale angeboten werden. Solche Überprüfungen können sich daher auf eine Wiedergabe der logischen Zustände beschränken.

Es ist bekannt, interne Knoten in hochintegrierten Schaltungen mit einer mechanischen Messspitze zu überprüfen. Für die Untersuchung interner Busse sind jedoch so viele mechanische Messspitzen auf engstem Raum (etwa 2 μm Abstand zwischen zwei benachbarten Busleitungen) aufzusetzen, wie der Bus Leitungen aufweist. Dies ist jedoch aus technischen Gründen nicht möglich.

Die Elektronensonde hat sich in der Vergangenheit bereits vielfach bei der Überprüfung von internen Knoten in hochintegrierter Schaltung bewährt (E. Wolfgang et al: «Electron-Beam Testing of VLSI Circuits», IEEE J. Solid-State Circ., Vol. SC-14, No. 2, Apr. 1979, pp. 471–481, und P. Fazekas et al: «Der Elektronenstrahl als belastungsfreie Messsonde zur Untersuchung hochintegrierter MOS-Schaltungen», NTG-Fachberichte, Bd. 68, VDE-Verlag GmbH, Berlin, S. 149–152 [1979]). Zur Untersuchung von Mikroprozessoren und Mikrocomputern mit Datenbreiten bis zu 16 Bit und mehr ist jedoch eine neue Technik erforderlich, welche die Vorgänge auf allen Datenleitungen gleichzeitig darstellen kann.

Erste Untersuchungen mit der Elektronensonde an Mikroprozessoren wurden 1978 von Feuerbaum und Hernaut an dem Mikrosequenzer eines 4-Bit-Mikroprozessors durchgeführt (H.P. Feuerbaum et al, «Appl. of Electron Beam Measuring Techniques for Verification of Computer Simulations for Large-Scale Integrated Circuits», SEM/1978, Vol. 1, pp. 795–800). In späteren Arbeiten wurde gezeigt, dass eine Reihe von weiteren Funktionen in Mikroprozessoren mit verschiedenen anderen Elektronenstrahl-Messtechniken geprüft werden können (G. Crichton et al, «Electron Beam Testing of Microprocessors», Digest of Papers 1980, IEEE Test Conference, pp. 444–449, 1980).

Aus «Technisches Messen» tm 48 (1981), Heft 1, S. 29–35 ist ein Verfahren nach dem Oberbegriff des Anspruchs 1 bekannt. Wie anhand von Bild 4 dieser Veröffentlichung gezeigt ist, werden dabei zur Erstellung eines Logikbildes sowohl das zu überprüfende Messobjekt als auch der zum Rasterelektronenmikroskop gehörende Bildschirm synchron in zwei räumlichen Dimensionen abgerastert. Während dabei beim Abrastern die Zeile (Zeilenrichtung parallel zur x-Achse) langsam in y-Richtung den elektronischen Baustein bzw. den Bildschirm überstreicht, wird die Phasenlage des Eintastpulses bezüglich der Wiederholfrequenz der Programmschleife von 0° bis 360° verändert. Dabei wird ein Logikbild erzeugt, das einen Bausteinausschnitt wiedergibt, der vom Zeitdiagramm der logischen Signale auf den abgebildeten Leitbahnen überlagert ist.

Dieses bekannte Verfahren ist für integrierte Schaltungen mit einer Nennfrequenz im GHz-Bereich nicht geeignet. Ausserdem ist dieses bekannte Verfahren für eine Messung an parallelen, kurzen Leitbahnen innerhalb einer integrierten Schaltung nicht geeignet.

Der vorliegenden Erfindung liegt die Aufgabe zugrunde, ein Verfahren der eingangs genannten Art für eine rasche interne Logikprüfung an elektrischen Schaltungen anzugeben, wobei die Vorgänge auf allen Datenleitungen eines Busses innerhalb einer integrierten Schaltung gleichzeitig dargestellt werden können.

Diese Aufgabe wird erfindungsgemäss durch ein Verfahren nach dem Anspruch 1 gelöst. Weiterbildungen der Erfindung sind in den Ansprüchen 2 bis 4 angegeben.

Die Erfindung basiert auf der Tatsache, dass der Elektronenstrahl einfach und schnell positioniert werden kann. Um den Betrieb der Vorrichtung zu realisieren, wird der gepulste Elektronenstrahl bei fester Phasenlage des Ablaufzyklus der integrierten Schaltung hintereinander auf verschiedene Messstellen gerichtet. Dabei wird von jeder Messstelle das Potential-Kontrastsignal registriert und logisch bewertet. Die bei einer festen Phasenlage des Ablaufzyklus der integrierten Schaltung gewonnenen Messergebnisse werden an den Rechner oder Logikanalysator weitergegeben. Auf diese Weise können von verschiedenen Phasenlagen des Ablaufzyklus der integrierten Schaltung Messergebnisse an den Rechner oder Logikanalysator weitergegeben werden, und zwar solange, bis der gewünschte Phasenbereich (z.B. Programmabschnitt) aufgezeichnet ist. Schliesslich werden diese Messergebnisse im Rechner oder Logikanalysator ausgewertet.

Ein Einspeisen der Messergebnisse in einen Logikanalysator oder Rechner bietet die Vorteile, dass die Messergebnisse in Zeitdiagrammen übersichtlich dargestellt werden können und dass die Messergebnisse in einer hexadezimalen Darstellung aufgelistet werden können. Vorteilhaft ist ebenso zu werten, dass daneben alle Auswertehilfen des Rechners oder Logikanalysators zur Verfügung stehen.

Die Darstellung der Messergebnisse in einem Zeitdiagramm wird als Logikdiagramm bezeichnet. Mit der Elektronensonde kann die zeitliche Folge logischer Zustände auf mehreren Datenleitungen gleichzeitig in einem Logikdiagramm dargestellt werden. Zur Erstellung des Logikdiagrammes springt der Elektronenstrahl von Messstelle zu Messstelle, was in Anlehnung an die Elektronenlithografie als Vektorsonden-Technik bezeichnet wird.

Der Informationsgehalt eines solchen Logikdiagrammes entspricht dem eines Logikdiagrammes eines konventionellen Logikanalysators, wie er zur Prüfung von Mikrocomputern und Rechnern verwendet wird (J. McLeod «Logic Analyzers – Sharp Fault-Finders Getting Sharper», Electronic Design, Vol. 28, 1980, 7, S. 48–56). Die Aufnahme eines Logikdiagrammes entsprechend einem Logikdiagramm eines Logikanalysators verbessert erheblich die Übersicht über die Messergebnisse.

Die Erfindung ist in der Zeichnung dargestellt und wird im folgenden anhand eines Beispiels näher beschrieben.

Fig. 1 zeigt den zeitlichen Ablauf eines erfindungsgemässen Logikprüfungsverfahrens bei fünf Messpunkten.

Fig. 2 zeigt ein Blockschaltbild der Messanordnung zur Aufnahme von Logikdiagrammen.

Die im folgenden beschriebene Technik baut auf früheren Arbeiten von Feuerbaum («Beiträge zu Fortschritten in der Elektronenstrahlmesstechnik», in Beiträge zur elektronenmikroskopischen Direktabbildung von Oberflächen 11, S. 67–71, 1978 bzw. Feuerbaum und Wolfgang «Use of SEM for Multichannel Sampling Oscillography», Proc. of the IEEE, Vol. 66, No. 8, pp. 984–985, 1978) auf. In der letztgenannten Druckschrift ist ein Verfahren beschrieben, bei dem 16mal pro Sekunde abwechselnd ein erster Signalverlauf an einem ersten Schaltungsknoten und sodann anschliessend ein zweiter Signalverlauf an einem zweiten Schaltungsknoten jeweils vollständig gemessen und auf dem Bildschirm eines Raster-Elektronenmikroskops dargestellt werden, so dass für einen Betrachter der Eindruck eines stationären Bildes entsteht. Die experimentellen Untersuchungen wurden an einem unpassivierten Mikroprozessor 8085® durchgeführt, der in einer verkleinerten Version entwickelt und hergestellt worden ist.

Die Technik zur Herstellung eines Logikdiagrammes beruht auf dem Sampling-Prinzip (L. Balk et al, «Quantitative Voltage Contrast at high Frequencies in the SEM», SEM/1976, pp. 615–624). Das bedeutet in der Elektronenstrahl-Messtechnik, dass die Elektronensonde mit der Frequenz der Programmschleife gepulst, und die Phase über die gesamte Schleife oder Teile davon geschoben wird. Die Programmschleifen sollen dabei so kurz wie möglich sein, da das Puls-Pauseverhältnis bei den Sampling-Techniken mit der Elektronensonde nicht zu klein sein darf (A. Gopinath, «Estimate of Minimum Measurable Voltage in the SEM», J. Phys., E: Sci. Instrum., Vol. 10, No. 9, pp. 911–913, 1977).

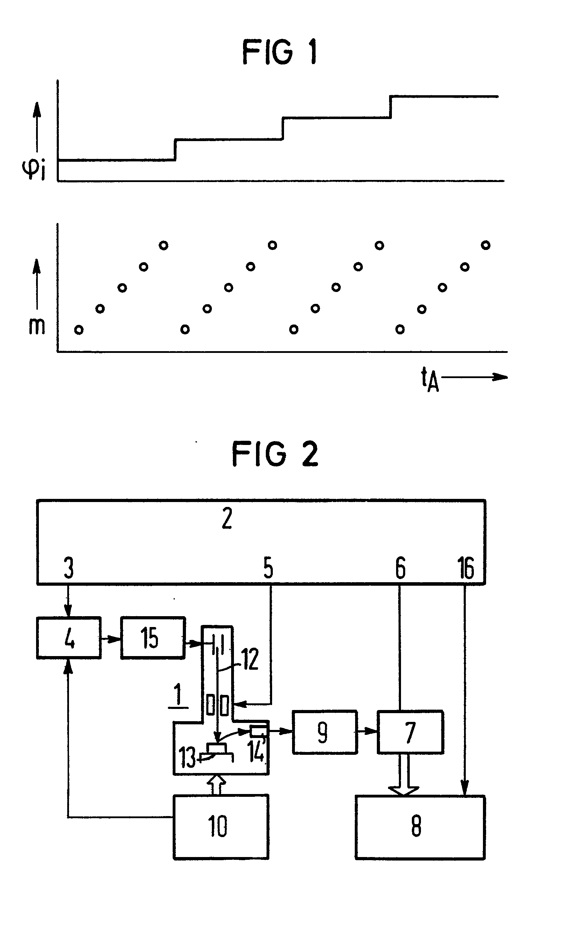

Fig. 1 zeigt den zeitlichen Ablauf zur Herstellung eines Logikdiagrammes bei fünf Messpunkten. Der aufzuzeichnende Zeitbereich wird über die Aufnahmezeit $t_A$ hinweg in Phasenpunkte $\varphi_i$ aufgeteilt. Die gepulste Elektronensonde springt zunächst bei konstanter Phase, das bedeutet, dass dabei der Einschaltzeitpunkt der Elektronensonde bezüglich des Triggersignals der Programmschleife (Ansteuerung der zu untersuchenden Schaltung) zunächst konstant ist, nacheinander von einem Messpunkt m zu einem anderen Messpunkt m, und zwar so lange, bis von allen fünf Messpunkten bei der konstanten Anfangsphase Messergebnisse vorliegen. Die Verweilzeit der gepulsten Elektronensonde auf den Messpunkten wird dabei so gewählt, dass die logischen Zustände «0» und «1» sicher unterschieden werden können. Ist die Elektronensonde bei konstanter Anfangsphase am letzten Messpunkt angelangt, springt sie wieder zum ersten Messpunkt zurück, wobei sich die Phase um einen einstellbaren diskreten Wert ändert. Die gepulste Elektronensonde springt so lange bei jeweils geänderter Phase vom ersten bis zum letzten Messpunkt, bis die gesamte Programmschleife oder bestimmte gewünschte Teile davon abgebildet sind.

Fig. 2 zeigt das Blockschaltbild einer Messanordnung für die Erstellung eines Logikdiagrammes. Diese Messanordnung basiert auf einem modifizierten Raster-Elektronenmikroskop 1 (Etec-Autoscan) (E. Wolfgang et al, «Internal Testing of Microprocessor Chips Using Electron Beam Techniques», Proc. of IEEE International Conference on Circuits and Computers 1980, pp. 548–551, 1980). Der Ablauf der Messung wird von einem Rechner 2 (Interdata® 6/16) gesteuert. Die Phasensteuerung 3 erfolgt über einen D/A-Wandler und einen Verzögerungsgenerator 4. Die Positionierung der einzelnen Messstellen erfolgt mittels eines digitalen Rastergenerators 5. Der Schiebetakt 6 bewirkt die Übernahme der bewerteten Messwerte (logisch «0» oder «1») in ein Schieberegister 7. Sind alle Messwerte einer Phasenlage im Schieberegister 7 gespeichert, werden sie vom Logikanalysator 8 (Biomation® K 100) übernommen. Bewertet wird das Spannungssignal mittels einer Schmitt-Trigger-Schaltung 9 (Feuerbaum, «VLSI-Testing Using the Electron Probe», SEM/1979, pp. 285–296, 1979). Die Ansteuerung des verwendeten Mikroprozessors 13 (8085®) erfolgt durch ein Mikroprozessor-Laboratorium 10 (HP μ-Lab® 5036 A). Mit 12 ist die gepulste Elektronensonde und mit 14 der Sekundärelektronen-Kollektor bezeichnet.

Bei Messungen auf dem internen Datenbus eines Mikroprozessors 8085® mit einem erfindungsgemässen Verfahren wurden die eingegebenen Programmschleifen exakt wiedergegeben. Die Bedeutung des Logikanalysators für die Prüfung von Rechnersystemen mit grosser Datenbreite ist unbestritten. Mit der Erfindung ist es nun auch innerhalb integrierter Schaltungen möglich, Logikdiagramme mit Hilfe der Elektronensonde zu erhalten. Schwächen und Fehler in Mikroprozessoren und Mikrocomputern, die mit anderen Mitteln nicht zu erfassen waren, konnten bereits erfolgreich aufgeklärt werden.

Die Zahl der Messstellen richtet sich nach dem verwendeten Logikanalysator: Bei den durchgeführten Messungen konnten 16 Messstellen überprüft werden. Die Zeitauflösung der Anordnung hängt von der Breite der Elektronenpulse ab. Mit der verwendeten Vorrichtung waren 1 ns breite Pulse routinemässig erzielbar, was bedeutet, dass ein 1-GHz-Logikanalysator für zyklische Programmabläufe realisiert werden konnte. Das beschriebene Verfahren hat gegenüber der quantitativen Messung nicht nur den Vorteil, dass ohne Spektrometer und Regelstrecke gearbeitet werden kann, weil eine Schwellwertschaltung direkt das Video-Signal bewertet und als Messwert den logischen Zustand liefert, sondern auch den Vorteil der erheblich grösseren Aufzeichnungsgeschwindigkeit. Ein Logikdiagramm kann in weniger als 1000stel der Zeit aufgezeichnet werden, die für ein Logikbild nach dem Stand der Technik benötigt wird, weil durch die Vektorsonden-Technik nur die relevanten Messwerte erfasst werden.

Mit 15 ist der Pulsgenerator bezeichnet; der Ausgang 16 des Rechners 2 bewirkt die Messwertübernahme aus dem Schieberegister 7 in den Logikanalysator 8.

Bei Verwendung eines Logikanalysators ist die Erfindung nicht darauf beschränkt, dass nach jedem Rastern entlang einer Zeile («line scanning»), das bei einer festen Phasenlage durchgeführt worden ist, die im Zwischenspeicher befindlichen Messergebnisse parallel an den Logikanalysator 8 weitergegeben werden; ebenso kann eine beliebige Anzahl von jeweils parallel an einen Logikanalysator aus dem Zwischenspeicher abzugebenden Messergebnissen in diesem Zwischenspeicher verbleiben, ehe diese Messergebnisse an den Logikanalysator weitergegeben werden. Zum Beispiel können auch überhaupt sämtliche Messergebnisse von allen Phasenlagen einer Programmschleife zunächst in einen Zwischenspeicher eingespeichert werden, ehe sie an den Logikanalysator weitergegeben werden.

Der Logikanalysator kann durch eine jede Vorrichtung ersetzt werden, welche logische Messergebnisse speichern und auswerten kann. Die Messergebnisse können vom Ausgang des Bewerters 9 weg z.B. direkt in den für die Ablaufsteuerung verwendeten Rechner (Interdata® 6/16) eingespeichert und dort ausgewertet werden. Selbstverständlich können die Messergebnisse vom Ausgang des Bewerters 9 weg auch in einen anderen Rechner eingespeichert und in diesem oder in einem weiteren Rechner ausgewertet werden.

Um die Auswertung eines aufzunehmenden Logikdiagrammes zu beschleunigen, brauchen bei einem erfindungsgemässen Verfahren in den Rechner oder in den Logikanalysator nur solche Messergebnisse von Phasenlagen eingespeichert zu werden, die eine frei wählbare Bedingung erfüllen. Zum Beispiel können Messergebnisse von solchen Phasenlagen weggelassen werden, bei denen keine logischen Zustandsänderungen erfolgen.

## Patentansprüche

1. Verfahren zur Darstellung der an Messpunkten einer programmgesteuerten integrierten Schaltung (13) während der zyklisch wiederholten Abarbeitung einer Programmschleife zu bestimmten Zeitpunkten jeweils auftretenden logischen Zustände, bei dem eine mit der Wiederholfrequenz der Programmschleife gepulste Elektronensonde (12) in einem Raster-Elektronenmikroskop (1) bei einer bezüglich der Wiederholfrequenz der Programmschleife bestimmten Phasenlage hintereinander auf verschiedene Messpunkte gerichtet wird, bei dem von jedem Messpunkt ein Potentialkontrast-Signal als Messergebnis gewonnen wird, bei dem sodann die Phasenlage der Elektronenpulse bezüglich der Wiederholfrequenz der Programmschleife geändert wird, bei dem bei dieser neuen Phasenlage der Elektronenpulse bezüglich der Wiederholfrequenz der Programmschleife die Elektronensonde (12) wieder auf verschiedene Messpunkte gerichtet wird, so lange, bis auch bei der bezüglich der Wiederholfrequenz der Programmschleife neu eingestellten Phasenlage der Elektronenpulse von diesen Messpunkten Messergebnisse vorliegen, bei dem die Phasenlage der Elektronenpulse bezüglich der Wiederholfrequenz der Programmschleife so lange jeweils neu eingestellt wird und bei dem so lange bei jeweils neu eingestellter, aber bezüglich der Wiederholfrequenz der Programmschleife fester Phasenlage der Elektronenpulse Messergebnisse gewonnen werden, bis die gesamte Programmschleife oder bestimmte gewünschte Teile davon abgetastet worden ist bzw. sind, dadurch gekennzeichnet,

– dass als Messpunkte verschiedene Schaltungsknoten gewählt werden,
– dass die Elektronensonde (12) bei jeder bezüglich der Wiederholfrequenz der Programmschleife neu eingestellten Phasenlage der Elektronenpulse immer wieder dieselben Schaltungsknoten abtastet,
– dass bei der bezüglich der Wiederholfrequenz der Programmschleife neu eingestellten Phasenlage die Elektronensonde (12) von einem Schaltungsknoten zum nächsten Schaltungsknoten springt,
– dass die Elektronensonde (12) auf jedem Schaltungsknoten so lange verweilt, bis der logische Zustand dieses Schaltungsknotens eindeutig logisch bewertet werden kann, und
– dass die Messergebnisse in einem Rechner oder in einem Logikanalysator ausgewertet werden.

2. Verfahren nach Anspruch 1, dadurch gekennzeichnet, dass die Schaltungsknoten entlang einer Zeile innerhalb der integrierten Schaltung (13) angeordnet werden, dass die Elektronensonde (12) bei jeweils fester Phasenlage der Elektronenpulse bezüglich der Wiederholfrequenz der Programmschleife entlang dieser Zeile geführt wird und dass dabei die jeweiligen Messergebnisse gewonnen werden.

3. Verfahren nach Anspruch 1, dadurch gekennzeichnet, dass die Messergebnisse in hexadezimaler Darstellung aufgelistet werden.

4. Verfahren nach Anspruch 1, dadurch gekennzeichnet, dass nur solche Messergebnisse von Phasenlagen im Rechner oder Logikanalysator eingespeichert werden, die eine frei wählbare Bedingung bezüglich der logischen Zustände an den Schaltungsknoten erfüllen.

**Claims**

1. A method of representing the respective logic states which occur at the measuring points of a programme-controlled integrated circuit (13) when a programme loop is repeatedly worked out in a cycle at specific times, wherein an electron probe (12) pulsed at the repetition frequency of the programme loop is consecutively directed to different measuring points in a raster electron microscope (1) with a phase position determined in relation to the repetition frequency of the programme loop, wherein a potential contrast signal is obtained from each measuring point as a measurement result, wherein the phase position of the electron pulses in relation to the repetition frequency of the programme loop is subsequently changed, wherein in the new phase position of the electron pulses in relation to the repetition frequency of the programme loop the electron probe (12) is redirected to different measuring points until measurement results of these measuring points are likewise available in the phase position of the electron pulses which is readjusted in relation to the repetition frequency of the programme loop, wherein the phase position of the electron pulses in relation to the repetition frequency of the programme loop is respectively readjusted until such time and wherein in a phase position of the electron pulses which is respectively readjusted, but fixed in relation to the repetition frequency of the programme loop, measurement results are obtained until such time as the entire programme loop or specific required parts thereof has or have been scanned, characterised in
- that different nodes are selected as measuring points;
- that in each phase position of the electron pulses which is readjusted in relation to the repetition frequency of the programme loop, the electron probe (12) repeatedly scans the same node;
- that in the phase position which is readjusted in relation to the repetition frequency of the programme loop the electron probe (12) jumps from one node to the next node;
- that the electron probe (12) dwells on each node until the logic state of this node can be clearly logically evaluated; and
- that the measurement results are analysed in a computer or in a logic analyser.

2. Method as claimed in Claim 1, characterised in that the nodes are arranged along a line within the integrated circuit (13), that in a fixed phase position of the electron pulses in relation to the repetition frequency of the programme loop the electron probe (12) is moved along the line and that the respective measurement results are obtained thereby.

3. Method as claimed in Claim 1, characterised in that the measurement results are listed in a hexa-decimal display.

4. Method as claimed in Claim 1, characterised in that only measurement results of phase positions are stored in the computer or logic analyser which fulfil a freely selectable requirement in relation to the logic states at the nodes.

**Revendications**

1. Procédé pour représenter les états logiques se produisant sur des points de mesure d'un circuit intégré (13), commandé par programme, à des instants déterminés pendant l'exécution répétée cycliquement d'une boucle de programme, selon lequel une sonde électronique (12), dans un microscope électronique à balayage (1), alimentée en impulsions à la fréquence de répétition de la boucle de programme, est dirigée successivement sur différents points de mesure avec une relation de phase déterminée par rapport à la fréquence de répétition de la boucle de programme, selon lequel un signal de contraste de potentiel est tiré comme résultat de mesure de chaque point de mesure, selon lequel, ensuite, la relation de phase des impulsions électroniques par rapport à la fréquence de répétition de la boucle de programme est changée, selon lequel, avec cette nouvelle relation de phase des impulsions électroniques par rapport à la fréquence de répétition de la boucle de programme, la sonde électronique (12) est de nouveau dirigée sur différents points de mesure, jusqu'à ce que, également avec la relation de phase nouvellement ajustée des impulsions électroniques par rapport à la fréquence de répétition de la boucle de programme, des résultats de mesure de ces points de mesure soient disponibles et selon lequel la relation de phase des impulsions électroniques par rapport à la fréquence de répétition de la boucle de programme est chaque fois réajustée et des résultats de mesure sont obtenus avec chaque relation de phase nouvellement ajustée mais fixe par rapport à la fréquence de répétition de la boucle de phase, jusqu'à ce que toute la boucle de programme ou des parties déterminées désirées de cette boucle ait (aient) été explorée(s), caractérisé en ce que:
- on choisit différents nœuds de circuit comme points de mesure,
- la sonde électronique (12) explore toujours les mêmes nœuds de circuit à chaque relation de phase nouvellement ajustée des impulsions électroniques par rapport à la fréquence de répétition de la boucle de programme,
- la sonde électronique (12) saute d'un nœud de circuit au nœud de circuit suivant à chaque relation de phase nouvellement ajustée par rapport à la fréquence de répétition de la boucle de programme,

– la sonde électronique (12) reste sur chaque nœud de circuit le temps nécessaire à l'évaluation univoque de l'état logique de ce nœud de circuit, et

– les résultats de mesure sont exploités dans un calculateur ou dans un analyseur logique.

2. Procédé selon la revendication 1, caractérisé en ce que les nœuds de circuit sont disposés le long d'une ligne dans le circuit intégré (13), que la sonde électronique (12) est guidée le long de cette ligne chaque fois la relation de phase des impulsions électroniques par rapport à la fréquence de répétition de la boucle est fixe et que les résultats de mesure concernés sont obtenus pendant cette opération.

3. Procédé selon la revendication 1, caractérisé en ce que les résultats de mesure sont listés dans une représentation hexadécimale.

4. Procédé selon la revendication 1, caractérisé en ce que seuls les résultats de mesure de positions de phase remplissant une condition, pouvant être choisie librement, relative aux états logiques sur les nœuds de circuit, sont mémorisés dans le calculateur ou l'analyseur logique.

# FIG 1

# FIG 2